(19) Europäisches Patentamt
European Patent Office
Office européen des brevets

(11) Veröffentlichungsnummer: **0 184 225**
**A2**

# (12) EUROPÄISCHE PATENTANMELDUNG

(21) Anmeldenummer: **85116310.5**

(22) Anmeldetag: **25.08.82**

(51) Int. Cl.⁴: **G01N 24/08**, G01N 24/00

(30) Priorität: **07.09.81 DE 3135335**

(43) Veröffentlichungstag der Anmeldung: **11.06.86 Patentblatt 86/24**

(60) Publication number of the original application in accordance with Art.76 EPC: **0 074 022**

(84) Benannte Vertragsstaaten: **FR GB NL**

(71) Anmelder: **Siemens Aktiengesellschaft**
**Berlin und München Wittelsbacherplatz 2**
**D-8000 München 2(DE)**

(72) Erfinder: **Löffler, Wilfried, Dr.**
**542 Westgate Drive**
**Edison New Jersey 08820(US)**
Erfinder: **Oppelt, Arnulf, Dr.**
**Am Eichengarten 7**
**D-8520 Buckenhof(DE)**
Erfinder: **Siebold, Horst, Dr.**
**Starenweg 3**
**D-8520 Erlangen(DE)**

## (54) Kernspin-Tomographie-Verfahren.

(57) Die Erfindung betrifft ein Verfahren zur Darstellung der in einer Querschnittsebene eines Körpers vorliegenden Verteilung einer Kernspin-Eigenschaft, wie z.B. der Kernspin-Dichte. Dabei soll trotz unvermeidlicher Inhomogenitäten des magnetischen Gleichfeldes ein optimales Schnittbild erhalten werden. Es wird ein Gradientenfeld $G\phi$ angelegt, welches orthogonal zu einem Gradientenfeld $G_z$ gedreht wird. Dabei wird zunächst bei eingeschaltetem z-Gradient mittels eines geformten 90°-Hf-Pulses eine Schicht bei z = konstant angeregt. Nach Beendigung der Hf-Einstrahlung folgt ein $\phi$-Gradient konstanter Länge, worauf zum konstanten Zeitpunkt $t_{\pi 1}$ ein positiver oder negativer 180°-Hf-Puls folgt. An den 180°-Hf-Puls schließt sich ein z-Gradient an, auf den wieder der $\phi$-Gradient folgt, währenddessen das vollständige Kernspin-Echo gemessen wird, welches um den festen Zeitpunkt $t_{E1}$ als Symmetrie-Zentrum entsteht, um den daraus nach Fourier-Transformation erhaltenen Projektionen ein Bild der angeregten Schicht zu rekonstruieren. Das erfindungsgemäße Verfahren ist insbesondere in der medizinischen Diagnostik (Zeugmathographie) einsetzbar.

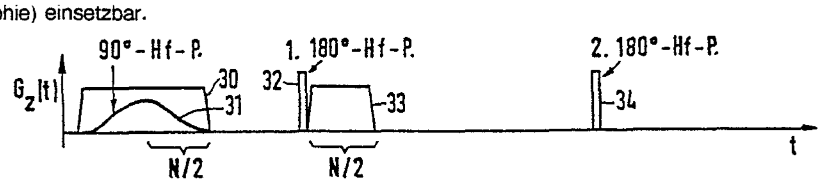


FIG 2

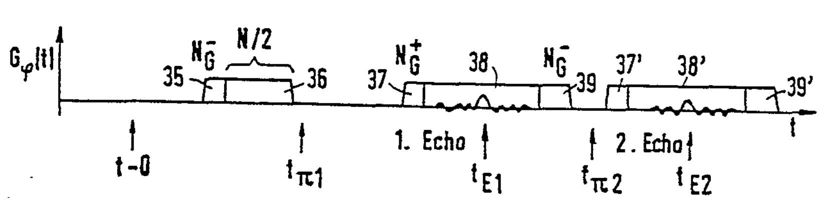


FIG 3

EP 0 184 225 A2

Rank Xerox

# Kernspin-Tomographie-Verfahren

Verfahren, die es gestatten, das Innere von Körpern von außen unter Anwendung von Kernspin-Resonanzeffekten bildlich darzustellen, sind auch unter Bezeichnungen wie Zeugmatographie, Spin-Imaging, Spin-Mapping oder FONAR bekannt geworden. Mit Hilfe solcher Verfahren ist es möglich, die Dichte bestimmter Isotope sowie die Verteilung der kernmagnetischen Relaxationszeiten über einen Körperquerschnitt abzubilden. Für die medizinische Diagnostik ist dabei von besonderer Wichtigkeit der an Wasser gebundene Wasserstoff. Damit kann man auf nichtinvasivem Wege Informationen über den physikalischen und chemischen Zustand lebenden Gewebes erhalten. Als Meßgrundlage werden dazu die bekannten Phänomene der magnetischen Kernspin-Resonanz herangezogen.

Bei der Durchführung von Diagnostikverfahren vorliegender Art wird der zu untersuchende Körper einem magnetischen Gleichfeld $B_0$ ausgesetzt und die nachzuweisenden Kernisotope werden durch ein Hochfrequenzfeld $B_1$ zur Präzession angeregt. $B_1$ muß dabei die durch das gyromagnetische Verhältnis gegebene Frequenz $\omega_0 = \gamma \cdot B_0$ haben. Die Zuordnung des infolge der Präzessionsbewegung in einer Empfängespule nachweisbaren Kernresonanzsignals zum Ort seiner Entstehung erfolgt durch die Anwendung linearer magnetischer Feldgradienten, wie z.B. von P.C. Lauterbur in "Nature" 242 (1973) Seiten 190/191 beschrieben.

Bei diesem Verfahren wählt man zweckmäßig die Polarkoordinaten $r$ und $\phi$ zur Beschreibung eines Ortes in der Bildebene. Wenn $G\phi$ die Stärke des Feldgradienten in $\phi$-Richtung ist, so ergibt sich die lokale Kernresonanzfrequenz $\omega(r)$ zu:

$$\omega(r) = \gamma(B_0 + G\phi \cdot r).$$

Damit ist es möglich, das Kernresonanzsignal anhand seiner Frequenz einem bestimmten Ort r entlang der $\phi$-Richtung zuzuordnen.

Bei einem aus der US-A-4070611 bekannten Verfahren wird innerhalb eines Abtastbezirks die Größe eines Grundmagnetfeldes und einer Hochfrequenz so gewählt, daß die kernmagnetische Resonanz angeregt wird. Ein 90°-Hochfrequenzimpuls wird senkrecht zur Richtung des Grundmagnetfeldes angelegt, wobei seine Intensität so gewählt wird, daß die magnetischen Momente der Kerne um 90° bezüglich des Grundmagnetfeldes ausgelenkt werden. Nach Beendigung des 90°-Impulses, zum Zeitpunkt $t_0$, tritt das HD-Signal auf. Sofort nach Beendigung des 90°-Impulses bis zu einer vorgegebenen Zeit $t_x$ wird ein x-Gradient des Magnetfeldes eingeschaltet. Nach Ablauf der Zeit $t_x$ wird für eine Zeit $t_y$ ein y-Gradient eingeschaltet. Nach Ablauf der Zeit $t_y$ wird der y-Gradient ausgeschaltet und ein z-Gradient eingeschaltet. Gleichzeitig mit der Einschaltung eines z-Gradienten wird das FID-Signal zu gleichen Zeitintervallen, z.B. 0,5 msec. mit einer bestimmten Zahl von Abtastungen N gemessen. Die Zeitspannen $t_x$ und $t_y$ werden relativ zueinander von einem Satz von N FID-Signalen, die Zeitspannen $t_x$ und $t_y$ relativ zueinander in einem weiten Bereich variieren. Die gemessenen Werte werden in einem Computer abgespeichert und der Ablauf wird mit einem Wechsel der z- und y-Gradienten wiederholt. Während der $t_y$-Periode werden die FID-Signale zu gleichen Zeitintervallen, z.B. 0,5 msec. N-mal für N FID-Signale mit einem sich ändernden Verhältnis von $t_y$ zu $t_z$ abgetastet. Entsprechend erhält man einen dritten Satz von Kernspin-Echos, indem man die z-Gradienten für die Periode $t_z$ und die x-Gradienten für die Periode $t_x$ vertauscht und eine Zahl N von FID-Signalen mit sich ändernden Verhältnissen von $t_z$ zu $t_y$ zu N Abtastzeitpunkten während der Periode $t_x$ abtastet.

Eine einfache Implementierung dieses Verfahrens bereitet Schwierigkeiten, da zum einen eine sehr kurze Anstiegszeit der Gradientenstromimpulse verlangt wird und zum anderen jede praktisch unvermeidbare Grundfeldinhomogenität zu einer Verringerung des Signals führt. Das in der vorliegenden Erfindung beschriebene Verfahren wird durch beide Unzulänglichkeiten nicht oder nur unwesentlich beeinflußt.

Aus der DE-A-2936465 ist ein Kernspin-Tomographie-Verfahren bekannt, bei dem die Probe zuerst mit einem Feldgradienten $G_x$ einem selektiven 90°-Hochfrequenzimpuls ausgesetzt wird. Unmittelbar nach dem Ende des ersten Hochfrequenzimpulses wird der Gradient in die z-Richtung umgeschaltet und die Magnetisierung kann während der Zeit $t_1$ in diesem Gradienten frei zerfallen. Der danach angelegte selektive Impuls dreht die Spins innerhalb einer Schicht mit einer gewissen Dicke um 180°. Dies bewirkt ein Echosignal zur Zeit $t_2$ nach dem Ende des HF-Impulses. Zum Zeitpunkt $t_2$ des Echo-Maximums wird der Gradient in die y-Richtung umgeschaltet und das resultierende Kernresonanz-Signal ausgelesen. Unmittelbar nach der beschriebenen Pulsfolge wird sofort eine zweite gleichartige Pulsfolge angewendet, um die Spins entlang einer Linie an anderer Stelle zu untersuchen.

Aus dem "Journal of Magnetic Resonance 18", 69-83 (1975), Seite 69 ist ein Kernspin-Tomographie-Verfahren bekannt, bei dem in einem ersten Zeitintervall ein x-Gradient, in einem anschließenden zweiten Zeitintervall ein y-Gradient und in einem dritten wiederum unmittelbar anschließenden Zeitintervall ein dritter Gradient zugeschaltet wird. Während des dritten Zeitintervalls wird der freie Induktionsabfall gemessen. Dieses Experiment wird für einen vollen Satz gleichbeabstandeter Werte des ersten und des zweiten Zeitintervalls durchgeführt.

Aus der GB-A-2048490 ist ein Kernspin-Tomographie-Verfahren bekannt, bei dem einem statischen Magnetfeld ein z-Gradient zusammen mit einem selektiven 90°-Hochfrequenzimpuls aufgeprägt wird, um Spinresonanz in einem vorgegebenen Streifen zu erzeugen. Der z-Gradient wird dann während eines begrenzten Zeitintervalls, währenddessen das freie Induktionssignal nur teilweise abklingt, ersetzt. Der x-Gradient ändert sich in einer Richtung, die senkrecht zu einer ausgewählten Scheibe des Streifens steht. Der x-Gradient wird dann sofort durch einen Y-(Lese-) Gradienten ersetzt, der sich in einer Richtung senkrecht sowohl zum x- als auch zum z-Gradienten hin ändert. Dann wird der freie Induktionsabfall gemessen. Diese Abfolge wird zyklisch wiederholt, wobei zwischen zwei Zyklen jeweils eine Pause auftritt.

Schließlich ist aus J.Phys.E.: Sci Instrum. Vol. 13, 1980, S. 747 bis 750 ein Kernspin-Tomographie-Verfahren bekannt, das mit $\phi$-Gradienten und nach dem Projektions-Rekonstruktionsverfahren arbeitet. Pulsfolgen für Gradienten- und Hochfrequenzfelder sind dort jedoch nicht angegeben.

Aufgabe der Erfindung ist es, bei gegebener technisch unvermeidbarer Inhomogenität des magnetischen Gleichfeldes ein bezüglich Signal-Rausch-Verhältnis und Freiheit von Artefakten optimales Schnittbild eines Körpers zu erzeugen.

Diese Aufgabe wird erfindungsgemäß gelöst durch die Merkmale des Patentanspruchs 1.

Bei den folgenden weiteren Erläuterungen von Details und Vorteilen der Erfindung wird auf bekannte Begriffe aus der Kernresonanz-Impulsspektroskopie, z.B. 90°- und 180°-Impuls, zurückgegriffen und auf die in den Figuren dargestellten Ausführungsbeispiele.

In der Fig. 1 ist schematisch das Blockschaltbild einer Vorrichtung dargestellt, die zur Durchführung des erfindungsgemäßen Kernspin-Tomographie-Verfahrens geeignet ist,

in den Fig. 2 und 3 in Diagrammen die Pulsfolgen für das erfindungsgemäße Verfahren,

in der Fig. 4 ein Beispiel des Anregungsschemas zur gleichzeitigen Messung mehrerer Schichten.

In der Fig. 1 sind mit 1 und 2 sowie 3 und 4 Spulen gekennzeichnet, mit welchen ein magnetisches Gleichfeld $B_o$erzeugt wird, in welchem sich bei Anwendung zur medizinischen Diagnostik der zu untersuchende Körper 5 eines Patienten befindet. Diesem sind außerdem Gradientenspulen zugeordnet, die zur Erzeugung unabhängiger, zueinander senkrechter Magnetfeldgradienten der Richtungen x, y und z gemäß der Andeutung in 6 vorgesehen sind. In der Figur sind der Übersichtlichkeit halber nur Spulen 7 und 8 gezeichnet, die zusammen mit einem Paar gegenüberliegender gleichartiger Spulen zur Erzeugung eines x-Gradienten dienen. Die gleichartigen nicht gezeichneten y-Gradientenspulen liegen parallel zum Körper 5 und oberhalb sowie unterhalb von ihm und die für das z-Gradientenfeld quer zu seiner Längsachse am Kopf- und am Fußende. Die Anordnung enthält außerdem noch eine zur Anregung der Kernresonanz und Aufnahme der Kernresonanzsignale dienende Hochfrequenzspule 9.

Die von einer strichpunktierten Linie 10 umgrenzten Spulen 1 bis 9 stellen das eigentliche Untersuchungsinstrument dar. Es wird von einer elektrischen Anordnung aus betrieben, die ein Netzgerät 11 zum Betrieb der Magnetspulen 1 bis 4 sowie eine Gradientenstromversorgung 12, an welcher die Spulen 7 und 8 sowie die weiteren Gradientenspulen liegen, umfaßt. Die sowohl zur Anregung als auch zur Aufnahme des Signals dienende Spule 9 liegt einerseits über einen Modulator 13 und einen Sendeverstärker 14 an einem Hochfrequenzoszillator 15 und andererseits über einen Signalverstärker 16 und einen phasenempfindlichen Gleichrichter 17 an einem Prozeßrechner 18, von dem aus zur Ausgabe der Abbildung ein Bildschirmgerät 19 versorgt wird. Zur Steuerung der Anordnung sind außerdem noch Verbindungen 20, 21 und 22 zwischen dem Rechner 18 und dem Modulator 13 sowie dem Oszillator 15 und dem Gleichrichter 17 sowie dem Rechner 18 und der Gradientenstromversorgung 12 vorgesehen.

Darauf läuft nach Einschaltung des Grundfeldes mit Hilfe der Gradientenstromversorgung und des Hf-Sende- und Empfangssystems beispielsweise die in den Fig. 2 und 3 skizzierte Sequenz ab. Es erfolgt zunächst die Anregung einer Schicht bei z = const durch einen selektiven 90°-Hf-Puls. Dazu wird der z-Gradient eingeschaltet. Gleichzeitig wird ein Hf-Puls eingestrahlt. Die Frequenz des Hf-Pulses richtet sich gemäß $\omega(z) = \gamma(B_o + G_z \cdot z)$ nach der Lage z der anzuregenden Schicht. Die Länge des Pulses beträgt N mal ein Grundzeitraster $\Delta t$, das je nach der Stärke der Gradienten und der Dicke der gewünschten Schicht eingestellt wird und in der Größenordnung von 100 µs liegt. N ist beispielsweise 128. Es folgen Gradientenstrompulse $G\phi$. mit einer Länge von $(N_G + N/2) \cdot \Delta t$ wobei die Zahl $N_G$ so gewählt werden muß, daß nach der Zeit $N_G \cdot \Delta t$ der Gradientenstrom seinen konstanten Wert nach der ansteigenden Flanke erreicht hat. Nach einem 180°-Hf-Impuls 32 wird wieder der z-Gradient für $N/2 \cdot \Delta t$, hier mit 33 bezeichnet, eingeschaltet. Im darauffolgenden $\phi$-Gradientenpuls der Dauer $(N_G^{+} + N + N_G) \cdot \Delta t$ mit den Bezeichnungen 37, 38, 39 entsteht ein Echo des Kernresonanzsignals, das über die Hochfrequenzelektronik abgetastet und ausgegeben wird. Dabei ist vorausgesetzt, daß die Gradientenwirkung während der Zeit $N_G^{-} \cdot \Delta t$ (39) vor dem 180°-Puls (32) gleich der Gradientenwirkung während der Zeit $N_G^{+} \cdot \Delta t$ (37) nach dem 180°-Puls ist.

Die Zusatzintervalle $N_G^{+}$ stellen die Konstanz der Gradientenfeldstärke während der Meßwerterfassung sicher.

Es ist zusätzlich möglich, mit Hilfe eines weiteren 180°-Pulses 34 und eines $\phi$-Gradientenpulses 37', 38', 39' ein weiteres Echo zu erzeugen und auszuwerten. In weiteren Scans werden die Experimente dann sinngemäß wiederholt, wobei der Winkel $\phi$ die x-y-Ebene überstreicht und bei jedem Ablauf um einen Betrag $\Delta\phi$ erhöht wird. Falls die Drehung des $\phi$-Gradientenfeldes durch mechanische Drehung der Spulenanordnung geschieht, genügt eine monopolare Stromversorgung. Bei zwei zueinander orthogonalen Spulenanordnungen muß die eine Amplitude $G_x$ von Ablauf zu Ablauf mit cos $\phi$, die andere $G_y$mit sin$\phi$ variieren. Überstreicht $\phi$ den Winkelbereich von 0 bis 180°, so muß die Stromversorgung der x-Gradientenspule bipolar ausgelegt sein.

Jeder Meßsatz wird fouriertransformiert zu einer Projektion. Aus allen Projektionen wird mit den in der Röntgen-Computertomographie üblichen Algorithmen das Bild errechnet, das mit dem Bildschirmsichtgerät 19 dargestellt wird.

Die Beschränkung auf nur eine Schicht hält die Gesamtmeßzeit für ein Bild kurz, was für die medizinische Anwendung wichtig ist. Außerdem sind die Ansprüche an die Dynamik des Vorverstärkers 16 und der Analog-Digital-Wandler, die in Fig. 1 als Teil des Prozeßrechners betrachtet werden, kleiner als bei Verfahren, die gleichzeitig das Signal aus dem ganzen Volumenbereich verwerten.

Wie von A. Kumar, D. Welti und R. R. Ernst (J. Magn. Res. 18 (1975) 69) vorgeschlagen, kann man die Verteilung eines Kernresonanzparameters als Funkton des Ortes (x, y) mittels zweidimensionaler Fourier-Transformation aus gemessenen Signalwerten S (t, $N_y$) berechnen, wenn diese die Fourier-Koeffizienten $S(k_x, ky)$ dieser Verteilung darstellen. $k_x$ und $k_y$ beschreiben die Wellenzahlen der jeweiligen Richtung und sind gegeben durch

$$k_x(t) = \gamma \int_0^t G_x(t')\,dt'$$

$$k_y(t) = \gamma \int_0^t G_y(t')\,dt'$$

Hierzu äquivalent läßt sich ein Kernresonanzparameter als Funktion von Polarkoordinaten (r, $\phi$) beschreiben. Aus Signalwerten S (t, $\phi$) läßt sich eine Projektion in Richtung $\phi$ gewinnen, wenn diese die Fourier-Koeffizienten S (K $\phi$, $\phi$) dieser Verteilung darstellen.

K$\phi$ ist die Wellenzahl in Richtung $\phi$ und ist gegeben durch

$$k_{\varphi}(t) = \gamma \int_0^t G_{\varphi}(t')\,dt'$$

Beschreibt man die Phasenlage der durch den 90°-Hf-Puls erzeugten transversalen Magnetisierung eines Volumenelements am Ort (r, $\phi$) durch eine komplexe Zahl in dem mit $\gamma B_0$ rotierenden Bezugssystem, so ist zu messen:

$S(k\phi, \phi) \sim \exp(i\,k\phi .\ r)$

Die Messung des komplexen Signals S (k$\phi$, $\phi$) erfolgt apparativ durch phasenempfindliche Gleichrichtung mit dem Senderoszillator als Referenz. Um eine reelle Projektion aus N Punkten mit guter Schärfe und gutem Kontrast zu erhalten, genügt für K$\phi$ ein Weitevorrat

$K\phi = O \text{ ---- } (N/2 - 1) .\ \Delta k\phi$

Man müßte den Realteil des komplex fouriertransformierten Signals, die "Absorption", als Projektionswert für die Weiterverarbeitung nehmen, und den Imaginärteil, die "Dispersion", verwerfen, da diese wegen ihrer weiten Flügel für die Abbildung nicht taugt.

In der Praxis tritt aber zu obigem Idealsignal noch ein unbekannter Phasenfaktor hinzu, der von Grundfeld-Inhomogenitäten und -Drifts und von nicht perfektem Elektronik-Abgleich herrührt. Dies bewirkt bei der rechnerischen Verarbeitung eine dispersive Beimischung zum realen Bildwert und damit eine Qualitätsverschlechterung.

Es ist daher besser, für k$\phi$ einen vollständigen Wertevorrat, also doppelt so viele Meßwerte

$k\phi = (-N/2) .\ \Delta k\phi \text{ ---- } (N/2 - 1) .\ \Delta k\phi$

zu messen.

Damit ergibt die Fouriertransformation einen komplexen Bildwert mit Imaginärteil = 0 im Idealfall, bzw. einen örtlich scharf und kontrastreich aufgelösten Absolutbetrag des komplexen Bildwertes, falls die oben genannten Störungen eine Phasendrehung oder einen Phasengang über die Bildebene verursachen.

Die gemäß Fig. 2, 3 benutzte Pulsfolge erlaubt es, den vollständigen Wertebereich der Wellenzahl k$\phi$, (also auch die negativen Werte) mit nur <u>einer</u> Polarität der Gradientenfelder zu erzeugen. Die Elektronik für das schnelle Schalten der Gradientenfelder ist sehr aufwendig und müßte an sich für jede Polarität separat installiert sein, falls die Polarität innerhalb einer Pulsfolge zur Ausmessung positiver und negativer k$\phi$ - Komponenten gewechselt werden müßte.

Wir betrachten nun die Erzeugung der gewünschten k$\phi$ -Werte mittels der vorgeschlagenen Pulsfolge in Fig. 3. Der $\phi$-Gradientenpuls 35, 36 vor dem 180°-Hf-Puls mit der Dauer $(N_{\bar{G}} + N/2) .\ \Delta t$, wobei $\Delta t$ ein festes Zeitraster ist, produziert eine Magnetisierung $M^{-}_{x,y} \sim \exp(i\,k^{-}_{\phi} .r)$, mit $k^{-}_{\phi} = (N_{\bar{G}} + N/2) .\ \Delta t .\ \gamma G\phi$ . $G\phi$ ist die Stärke des $\phi$-Gradientenfeldes:

$$M^{-}_{xy} \sim \exp(i\,k^{-}_{\varphi} .\ r).$$

Der darauffolgende 180°-Hf-Puls 32 kehrt, gleich welche Phase er hat, die Vorzeichen der Phasen in der $M_{xy}$-Magnetisierung um:

$$M^{-}_{xy} \sim \exp(-i\,k^{-}_{\varphi} .\ r).$$

Der zweite $\phi$-Gradient beginnt mit einem Zeitintervall $N_G^+ \cdot \Delta t$, bezeichnet mit 37, währenddessen sich das Gradientenfeld stabilisiert und der Vorverstärker an der Empfangsspule sich von dem 180°-Hf-Puls und der Schaltflanke des $\phi$-Gradienten erholt. Bei kurzen Abfallflanken der Gradientenpulse ist $N_G^+ = N_G^-$; ansonsten kann man $N_G^+$ um einige wenige Takte $\Delta t$ länger wählen als $N_G^-$, um den Beitrag der Abfallflanke des x-Gradientenvorlaufes zu kompensieren; stattdessen kann auch das Abtasten der Meßwerte um einen entsprechenden Zeitverzug verschoben werden.

Wenn der erste Meßwert zu Beginn des Intervalles 38 aufgenommen wird, hat die Magnetisierung die Gestalt:

$$\exp\left[\, i\gamma G_\varphi \, (-N_G^- - N/2 + N_G^+)\, \Delta t \,.\, r \right]$$

und damit auch das Signal die zuvor geforderte Form

$$S(k_\varphi, \varphi) \sim \exp\left[ i\, k_\varphi\, r \right]$$

mit dem gewünschten Wertebereich für $k\phi$ . Für $k\phi = 0$, also zum Zeitpunkt $t = t_{E1}$ , sind alle Volumenelemente bezüglich r ohne Phasengang, so daß ein Signalmaximum, ein "Kernspin-Echo" entsteht.

Der z-Gradient 33 nach dem 180°-Hf-Puls 32 dient dazu, den Phasengang über der Schichtdicke $\Delta z$ zu minimalisieren, um so ein möglichst starkes Echo zu erzeugen. Bei symmetrischen 90°-Hf-Pulsen wird dies von einem negativen z-Gradienten oder, wie in unserem Falle, von einem positiven z-Gradienten nach einem 180°-Hf-Puls geleistet, der ungefähr halb so lang wie der 90°-Hf-Puls 31 ist (gleiche z-Gradientenfeldstärke vorausgesetzt).

Die Verwendung eines zentralen 180°-Hf-Pulses zur Erzeugung des Signals hat neben den monopolaren Gradienten noch einen weiteren, sehr wichtigen Vorteil. Zum Zeitpunkt $t_{E1}$ des Echos ist der Phasenfehler durch eine Grundfeld-Inhomogenität $\Delta B_o$, der sich vor dem 180°-Hf-Puls zu $\gamma.\Delta B_o \cdot t_{E1}/2$ aufsummiert hat, wieder zu Null geworden; ebenso ist der Phasengang innerhalb eines Volumenelementes aufgrund von $\partial\Delta B_o/\partial x, \partial\Delta B_o/\partial y, \partial\Delta B_o/\partial z$ zu diesem Zeitpunkt Null. Das Signal wird also mit geringst möglichen Phasenfehlern und deshalb auch mit einer durch die Grundfeldinhomogenität kaum beeinträchtigten Intensität gemessen. Das Signal wird nur durch den unvermeidlichen Phasengang gedämpft, der von dem gewollten Gradientenfeld $G\phi$ herrührt.

Das Signal wird insgesamt im wesentlichen durch die echte transversale Relaxationszeit $T_2$ der betrachteten Kerne in ihrer stofflichen Umgebung bestimmt.

$$S(k\phi, \phi) \sim \exp(-t_{E1}/T_2) \;.\; \exp(i\, k\phi \,.\, r)$$

Da bei jeder Pulsfolge die Meßwerte zum gleichen Zeitpunkt nach der Anregung erfaßt werden, sind auch alle Projektionen im Signal gleich gewichtet.

Durch einen weiteren 180°-Hf-Puls 34 nach dem oben beschriebenen Meßvorgang kann ein zweites Echo erzeugt werden. Direkt nach diesem zweiten 180°-Impuls hat die Magnetisierung die Gestalt:

$$M_{xy}(t > t_\pi 2) \sim \exp[-i\gamma\, G\phi\, (N/2 + N_G^-)\, \Delta t \,.\, r)$$

Symmetrisch zum zweiten 180°-Hf-Puls wird der $\phi$-Gradient entsprechend dem ersten Auslese-Intervall wieder eingeschaltet (37', 38', 39') Die Wellenzahl $k\phi$ läuft wieder von $\gamma G\phi$ (- N/2) $\Delta t$ bis $\gamma G\phi$ (N/2-1) $\Delta t$ wie beim ersten Echo und kann gleichartig wie das erste Echo verarbeitet werden.

Bei den Hf-Pulsen empfiehlt sich bekanntermaßen, von Puls zu Puls das Vorzeichen zu wechseln, damit Auswirkungen kleiner Hf-Feldstärke-Abweichungen vom Nominalwert sich nicht aufaddieren können.

Das beschriebene Abbildungsverfahren kann dahingehend modifiziert werden, daß durch den selektiven 90°-Impuls mehrere parallele Schichten gleichzeitig angeregt werden. Das Vorzeichen oder, anders ausgedrückt, die Phasenlage der Anregung wird dann für die einzelnen angeregten Schichten innerhalb einer sonst gleichen Meßsequenz sukzessive variiert, um mit Hilfe geeigneter Dekodierungsalgorithmen die Signalbeiträge der einzelnen Schichten aus dem Gesamtsignal gewinnen zu können. Da bei N parallelen gleichzeitig angeregten Schichten mindestens N Meßzyklen mit unterschiedlichem Anregungsvorzeichen für eine Dekodierung erforderlich sind, erhält man keine Verkürzung der Gesamtmeßzeit im Vergleich zur sukzessiven Messung der einzelnen Schichten. Man erhält jedoch ein um den Faktor $\sqrt{N}$ höheres Signal-Rausch-Verhältnis.

Fig. 13 zeigt als Beispiel eine geeignete Anregungssequenz für das gleichzeitige Ausmessen von vier Schichten. Bezeichnen $S_a$ - $S_d$ die bei diesen Experimenten erhaltenen Summensignale und $S_I$ bis $S_{IV}$ die bei Anregung jeder einzelnen Schicht erwarteten Signale, so gilt:

$$-S_a + S_b + S_c + S_d = 4\, S_I$$

$$S_a - S_b + S_c + S_d = 4\, S_{II}$$

$$S_a + S_b - S_c + S_d = 4\, S_{III}$$

$$S_a + S_b + S_c - S_d = 4\, S_{IV}$$

Durch Anwendung der erfindungsgemäßen Anregungssequenz erhält man also in vier Messungen die Signale der vier Ebenen mit einem Rauschabstand entsprechend einer Mittelung über vier Meßzyklen. Eine Verallgemeinerung auf N gleichzeitig angeregte Schichten ist entsprechend dem in der DE-OS 2936465 für N parallele Linien in einer Ebene angegebenen Verfahren ohne weiteres möglich.

## Ansprüche

1. Verfahren zur Darstellung der in einer Querschnittsebene eines Körpers vorliegenden Verteilung einer Kernspin-Eigenschaft, wie z.B. der Kernspindichte, mit einem Gradientenfeld $G\phi$, welches orthogonal zu einem Gradientenfeld

$G_z$ gedreht wird, wobei zunächst bei eingeschaltetem z-Gradient (30) mittels eines geformten 90°-Hf-Pulses (31) eine Schicht bei z = const angeregt wird, wobei nach Beendigung der Hf-Einstrahlung ein $\phi$-Gradient (35, 36) konstanter Länge folgt, worauf zum konstanten Zeitpunkt $t_{\pi 1}$ ein positiver oder negativer 180°-Hf-Puls (32) folgt, an den sich ein z-Gradient (33) anschließt, auf den wieder der $\phi$-Gradient (37, 38, 39) folgt, währenddessen das vollständige Kernspin-Echo gemessen wird, welches um den festen Zeitpunkt $t_{E1}$ als Symmetrie-Zentrum entsteht, um aus den daraus nach Fouriertransformation erhaltenen Projektionen ein Bild der angeregten Schicht zu rekonstruieren.

2. Verfahren nach Anspruch 1, **dadurch gekennzeichnet**, daß alle Gradientenspulen nur in einer Polarität während einer Pulsfolge geschaltet werden.

3. Verfahren nach Anspruch 1, **dadurch gekennzeichnet**, daß für eine Anzahl von N Meßpunkten auf einer Projektion etwa 1,5 . N Abläufe (Projektionen) vermessen werden.

4. Verfahren nach Anspruch 1, **dadurch gekennzeichnet**, daß den $\phi$-Gradientenpulsen konstante Verlängerungen hinzugefügt werden, so daß immer der Beitrag des Zusatzintervalls der Länge $N\bar{\tau}$ . $\Delta t$ vor dem 180°-Hf-Puls durch den Beitrag des Zusatzintervalles $N\overset{+}{\tau}$ . $\Delta t$ nach dem 180°-Hf-Puls unter Einschluß des Einflusses der endlichen Anstiegszeiten kompensiert wird, wobei das Zusatzintervall so groß gewählt ist, daß anschließend das Gradientenfeld seinen stationären Wert erreicht hat.

5. Verfahren nach den Ansprüche 1 bis 4, **dadurch gekennzeichnet**, daß weitere Kernspin-Echos erzeugt werden, um durch Mittelwertsbildung das Signal-Rausch-Verhältnis zu verbessern, indem weitere 180°-Hf-Pulse mit vorzugsweise alternierenden Vorzeichen und jeweils anschließenden $\phi$-Gradientenpulsen die in den Ansprüchen 8 bis 11 beschriebene Sequenz ergänzen und alle erzeugten Echos die gleiche Information für die Ortsauflösung enthalten.

6. Verfahren nach Anspruch 5, **dadurch gekennzeichnet**, daß bei im Sinne hinreichender spektraler Breite genügend starken, kurzen 180°-Hf-Pulsen während des ersten und der darauf folgenden 180°-Pulse der $\phi$-Gradient eingeschaltet bleibt und nur durch die 180°-Pulse in Vor- und Nachphase getrennt wird.

7. Verfahren nach Anspruch 1, **dadurch gekennzeichnet**, daß eine x = const-Schicht (bzw. y = const-Schicht) abgebildet wird, indem während des 90°-Hf-Pulses ein x-Gradient (bzw. ein y-Gradient) eingeschaltet wird, wobei alle $G_z$ -Pulse durch $G_x$-Pulse (bzw. $G_y$-Pulse) ersetzt sind und der anschließende $\phi$-Gradient jeweils in der Ebene der selektiv angeregten Schicht rotiert.

8. Verfahren nach Anspruch 1, **dadurch gekennzeichnet**, daß mittels der selektiven 90°-Hf-Pulse mehrere parallele Ebenen der zu untersuchenden Probe gleichzeitig angeregt werden und die überlagerten Signale ausgelesen werden, wobei durch eine geeignete Anregungssequenz in einer Abfolge mehrere Meßzyklen gewährleistet ist, daß die gewonnenen Meßwerte rechnerisch wieder den einzelnen Ebenen zugeordnet werden können.

81 P 5079 01

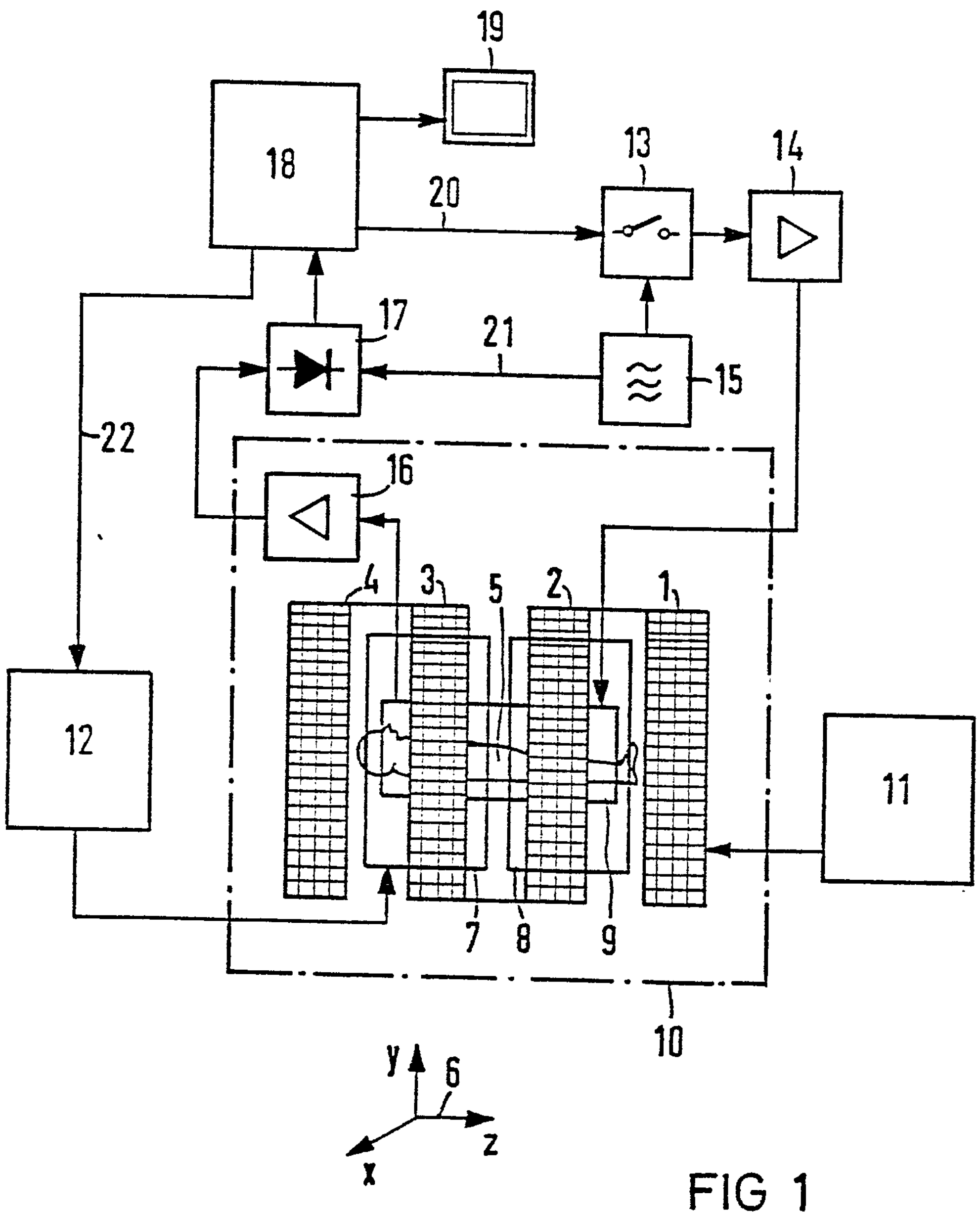


FIG 1

81 P 5079 01

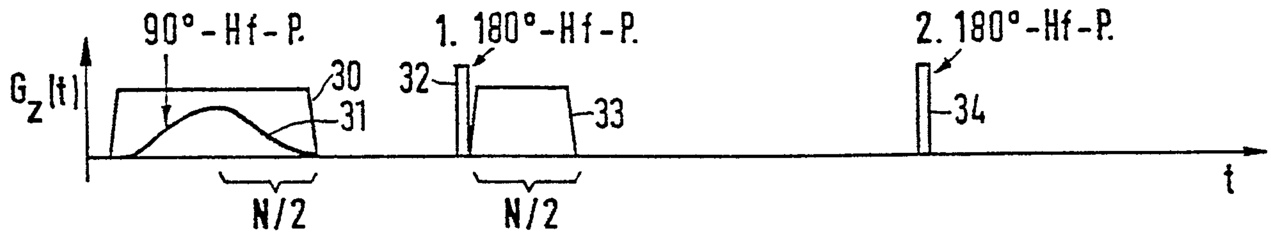


FIG 2

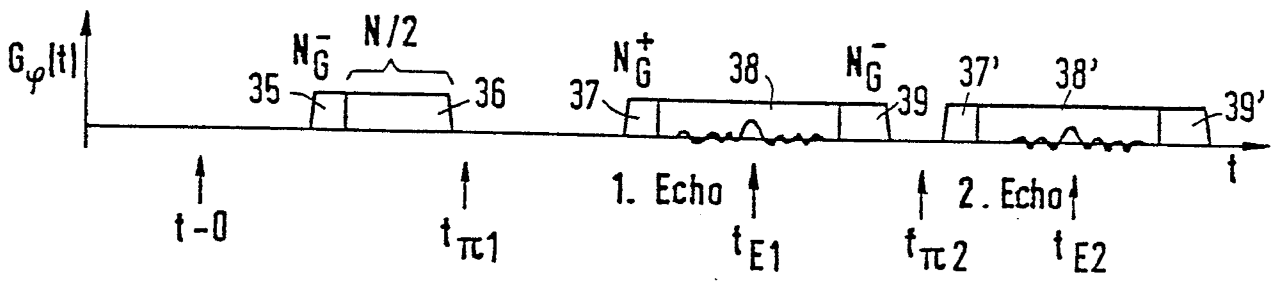


FIG 3

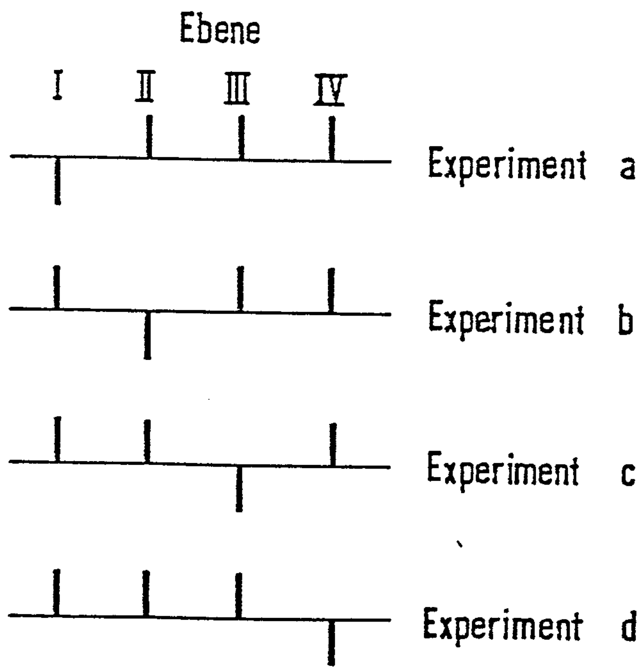


FIG 4